# EUROPEAN PATENT APPLICATION

(11) **EP 4 687 256 A1**
(43) Date of publication of application: **04.02.2026**
(21) Application number: 25159704.3
(22) Date of filing: 24.02.2025
(51) Int. Cl.: H02J 7/00, B60L 58/16, G01R 31/392, H01M 10/48

(54) **METHOD FOR BATTERY DERATING PROTECTION, ELECTRONIC DEVICE, AND STORAGE MEDIUM**

(30) Priority: 31.07.2024 CN 202411048972; 03.12.2024 WO PCT/CN2024/136288
(71) Applicant: Eve Energy Co., Ltd., Huizhou, Guangdong 516006 (CN)
(72) Inventor: DONG, Yapeng, Huizhou, 516006 (CN); LI, Wei, Huizhou, 516006 (CN); XIAO, Peng, Huizhou, 516006 (CN); SHANG, Jin, Huizhou, 516006 (CN); GUO, Qing, Huizhou, 516006 (CN)
(74) Representative: HGF

(57) **Abstract**

Provided are a method for battery derating protection, an electronic device, and a storage medium. In the method, application stages of a to-be-tested battery are correspondingly adjusted based on decline of a state of health of the to-be-tested battery (101, 201); in the case where the to-be-tested battery is in a beginning of life stage or a middle of life stage, a state-of-charge usage interval of the to-be-tested battery is set to an initial usage interval (102, 202); in the case where the to-be-tested battery transitions from the middle of life stage to an end of life stage, the state-of-charge usage interval is narrowed to a limited usage interval (103, 203); in the case where the to-be-tested battery transitions from the safety of life stage to the hazard of life stage, the to-be-tested battery is forcibly discharged to the lower limit of the limited usage interval (104, 204); after completing forced discharge, the state-of-charge usage interval of the to-be-tested battery is set to a single value (105, 205).

## Description

### TECHNICAL FIELD

The present application relates to the field of battery control, for example, a method for battery derating protection, an electronic device, and a storage medium.

### BACKGROUND

During the usage of batteries, the performance of the batteries inevitably deteriorates over time. If the batteries continue to be used based on the performance parameters of the batteries leaving the factory, degradation of the batteries' performance is further accelerated, and potential safety risks are posed. Therefore, reasonably adjusting usage strategies to accommodate changes in battery performance is key to ensuring battery safety and extending service life.

In the battery industry, it is common practice to make corresponding derating adjustments to the performance parameters of a battery according to its years of use, number of cycles, or the mileage of the vehicle served by a power battery.

Although making corresponding derating adjustments to the performance parameters of a battery according to its years of use, number of cycles, or the mileage of the vehicle served by a power battery helps manage the health of the battery to some extent, it often lacks a scientific assessment of the battery's actual performance changes and may even involve subjective judgment. This subjective derating may lead to an inappropriate reduction in the actual service life of the battery.

### SUMMARY

The present application provides a method for battery derating protection, an electronic device, and a storage medium to enhance battery safety while ensuring the battery life.

In a first aspect, an embodiment of the present application provides a method for battery derating protection. The method includes the steps below.

In an application process of a to-be-tested battery, application stages of the to-be-tested battery are correspondingly adjusted based on decline of a state of health of the to-be-tested battery, where the application stages include a beginning of life stage, a middle of life stage, an end of life stage, a safety of life stage, and a hazard of life stage ranked from high to low according to the state of health.

In response to the to-be-tested battery being in the beginning of life stage or the middle of life stage, a state-of-charge usage interval of the to-be-tested battery is set to an initial usage interval.

In response to the to-be-tested battery transitioning from the middle of life stage to the end of life stage, the state-of-charge usage interval is narrowed to a limited usage interval, where the range of the limited usage interval is less than the range of the initial usage interval.

In response to the to-be-tested battery transitioning from the safety of life stage to the hazard of life stage, the to-be-tested battery is forcibly discharged to a lower limit of the limited usage interval.

After completing forced discharge, the state-of-charge usage interval of the to-be-tested battery is set to a single value, where the single value is equal to the lower limit of the limited usage interval.

In a second aspect, an embodiment of the present application provides an electronic device. The device includes at least one processor and a memory communicatively connected to the at least one processor.

The memory stores a computer program executable by the at least one processor. The computer program is configured to, when executed by the at least one processor, cause the at least one processor to execute the method for battery derating protection described in any embodiment of the present application.

In a third aspect, an embodiment of the present application provides a computer-readable storage medium storing computer instructions that, when executed by a processor, implement the method for battery derating protection described in any embodiment of the present application.

In the method for battery derating protection, the electronic device, and the storage medium provided in the embodiments of the present application, in an application process of a to-be-tested battery, application stages of the to-be-tested battery are correspondingly adjusted based on decline of a state of health of the to-be-tested battery. In the case where the to-be-tested battery is in the beginning of life stage or the middle of life stage, a state-of-charge usage interval of the to-be-tested battery is set to an initial usage interval. In the case where the to-be-tested battery transitions from the middle of life stage to the end of life stage, the state-of-charge usage interval is narrowed to a limited usage interval. In the case where the to-be-tested battery transitions from the safety of life stage to the hazard of life stage, the to-be-tested battery is forcibly discharged to a lower limit of the limited usage interval. After completing forced discharge, the state-of-charge usage interval of the to-be-tested battery is set to a single value. In this manner, derating protection for the battery is achieved. On one hand, the derating protection of the state of charge is based on the state of health of the battery, which is scientific and reasonable, the shortening of battery life due to unreasonable derating is avoided, and the battery life is extended. On the other hand, the user's use of the battery beyond the warranty period is considered, and battery safety is enhanced.

### BRIEF DESCRIPTION OF DRAWINGS

FIG. 1 is a flowchart of a method for battery derating protection according to an embodiment of the present application.
FIG. 2 illustrates a relationship curve between the charging voltage and the charge capacity of a lithium iron phosphate battery during a charging process according to an embodiment of the present application.
FIG. 3 illustrates a relationship curve between the discharging voltage and the discharge capacity of a lithium iron phosphate battery during a discharging process according to an embodiment of the present application.
FIG. 4 illustrates a relationship curve between the charging voltage and the charge capacity of a nickel cobalt manganese lithium battery during a charging process according to an embodiment of the present application.
FIG. 5 illustrates a relationship curve between the discharging voltage and the discharge capacity of a nickel cobalt manganese lithium battery during a discharging process according to an embodiment of the present application.
FIG. 6 is a flowchart of a method for battery derating protection according to an embodiment of the present application.
FIG. 7 is a diagram showing the variation curves of various parameters throughout the entire lifecycle of a to-be-tested battery according to an embodiment of the present application.
FIG. 8 is a diagram illustrating the composition of an apparatus for battery derating protection according to an embodiment of the present application.
FIG. 9 is a diagram illustrating the composition of another apparatus for battery derating protection according to an embodiment of the present application.
FIG. 10 is a diagram illustrating the structure of an electronic device that can implement the embodiments of the present application.

### DETAILED DESCRIPTION

The terms "comprising", "including", and any other variations thereof in the description and claims of the present application and the preceding drawings are intended to encompass a non-exclusive inclusion. For example, a process, method, system, product, or device that includes a series of steps or units may also include other steps or units that are not expressly listed or are inherent to such a process, method, product, or device.

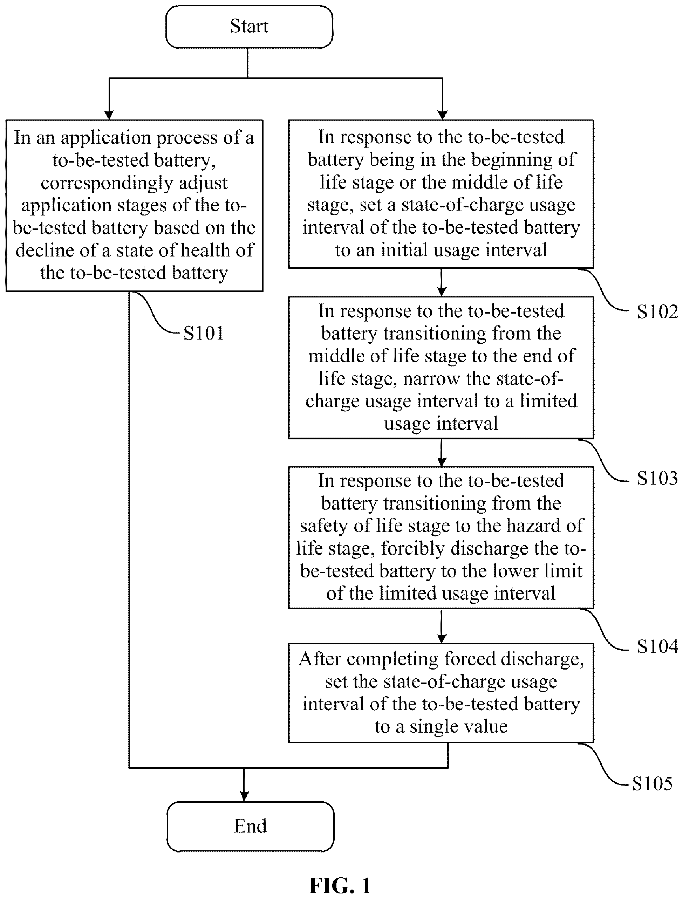

The present application proposes a method for battery derating protection that may be applied to a battery management system of a battery. FIG. 1 is a flowchart of a method for battery derating protection according to an embodiment of the present application. With reference to FIG. 1, the method for battery derating protection includes S101 to S105.

In S101, in an application process of a to-be-tested battery, application stages of the to-be-tested battery are correspondingly adjusted based on the decline of a state of health of the to-be-tested battery.

The state of health (SOH) is an important indicator used to describe battery performance and remaining service life. SOH reflects the battery's current health level relative to the initial state of the battery and may be determined in real time based on at least one of the battery's internal resistance, capacity, and voltage during use. The method for determining the SOH is part of related art and is not repeated here. The application stages refer to the various sub-stages in the lifecycle of the to-be-tested battery with different performance as the battery decays. The division of the application stages is based on the SOH of the battery. The application stages include a beginning of life (BOL) stage, a middle of life (MOL) stage, an end of Life (EOL) stage, a safety of life (SOL) stage, and a hazard of life (HOL) stage. Each application stage corresponds to an interval range of the SOH. During the application process of the to-be-tested battery, an application stage corresponding to the interval range may be determined as the current application stage of the to-be-tested battery based on the interval range of the current SOH of the to-be-tested battery.

Illustratively, the SOHs of the to-be-tested battery and the corresponding application stages are described in Table 1. The SOH range corresponding to the BOL stage is (90%, 100%], the SOH range corresponding to the MOL stage is (80%, 90%], the SOH range corresponding to the EOL stage is (70%, 80%], the SOH range corresponding to the SOL stage is (60%, 70%], and the SOH range corresponding to the HOL stage is (0, 60%]. When the SOH of the to-be-tested battery drops to 90%, the application stage of the to-be-tested battery is adjusted from the BOL stage to the MOL stage; when the SOH of the to-be-tested battery drops to 80%, the application stage of the to-be-tested battery is adjusted from the MOL stage to the EOL stage; when the SOH of the to-be-tested battery drops to 70%, the application stage of the to-be-tested battery is adjusted from the EOL stage to the SOL stage; when the SOH of the to-be-tested battery drops to 60%, the application stage of the to-be-tested battery is adjusted from the SOL stage to the HOL stage.

**Table 1 Comparison table of the SOH, corresponding application stage, and warranty status of a to-be-tested battery**

| SOH | Warranty Status | Application Stage |
|---|---|---|
| (90%, 100%] | within warranty | BOL |
| (80%, 90%] | | MOL |
| (70%, 80%] | | EOL |
| (60%, 70%] | out of warranty | SOL |
| (0, 60%] | | HOL |

In S102, in response to the to-be-tested battery being in the beginning of life stage or the middle of life stage, a state-of-charge usage interval of the to-be-tested battery is set to an initial usage interval.

The state-of-charge usage interval is also referred to as a state-of-charge usage window, which may show the upper limit and the lower limit of the change of the state of charge of the to-be-tested battery during the charging and discharging process. In the application process of the to-be-tested battery, once the state of charge of the to-be-tested battery exceeds the state-of-charge usage interval, the charging or discharging process is terminated so that the state of charge of the to-be-tested battery is kept within the state-of-charge usage interval. The initial usage interval refers to the state-of-charge usage interval of the to-be-tested battery when the battery leaves the factory, and the initial usage interval is [0%, 100%]. In the case where the to-be-tested battery is in the beginning of life stage or the middle of life stage, the state-of-charge usage interval of the to-be-tested battery is set to the initial usage interval.

Illustratively, in some embodiments, during the charging process of the to-be-tested battery, the state of charge of the to-be-tested battery may be detected in real time. Once the state of charge of the to-be-tested battery reaches 100%, it is determined that the battery is fully charged, and the charging is interrupted. In other embodiments, the voltage of the to-be-tested battery may be detected in real time during the charging process of the to-be-tested battery. Once the voltage of the to-be-tested battery reaches the voltage corresponding to 100% state of charge (the corresponding relationship curve between the state of charge and the corresponding voltage has been measured before the battery leaves the factory), it is determined that the battery is fully charged, and the charging is interrupted.

In S103, in response to the to-be-tested battery transitioning from the middle of life stage to the end of life stage, the state-of-charge usage interval is narrowed to a limited usage interval.

The range of the limited usage interval is less than the range of the initial usage interval and is within the range of the initial usage interval. Illustratively, in the case where the initial usage interval is [0%, 100%], the limited usage interval may be [10%, 90%]. The stage of the to-be-tested battery changes from the middle of life stage to the end of life stage, indicating that the health of the to-be-tested battery is reduced by 20% compared with the health of the to-be-tested battery leaving the factory. At this time, the battery capacity is much different from that at the factory, and overcharging and over-discharging aggravate the battery life decay. In this case, the state-of-charge usage interval is reduced to follow the change of health, which can optimize the customer experience and reduce safety risks.

When re-determining the state-of-charge usage interval in S102 and S103, not only the corresponding upper and lower limits of the state of charge may be determined but also the battery voltages corresponding to the upper and lower limits of the state of charge may e determined. In this manner, it is convenient for the battery control system of the to-be-tested battery to control the charge and discharge state of the to-be-tested battery based on the battery voltages corresponding to the upper and lower limits of the state-of-charge usage interval in the subsequent charging and discharging process. In some embodiments, the battery voltages corresponding to the upper and lower limits of the limited usage interval and the battery voltages corresponding to the upper and lower limits of the initial usage interval are determined based on a relationship curve between voltage and charge-discharge capacity of the to-be-tested battery during a charging and discharging process. The relationship curve between the voltage and the charge-discharge capacity of the to-be-tested battery during the charging and discharging process may be measured before the to-be-tested battery leaves the factory. Here, the charge-discharge capacity refers to the percentage of the charge and discharge capacity in the total capacity, which is equivalent to the state of charge. On the one hand, after setting the state-of-charge usage interval of the to-be-tested battery to the initial usage interval in S102, a battery voltage corresponding to an upper limit of the initial usage interval and a battery voltage corresponding to a lower limit of the initial usage interval may be determined based on the relationship curve, and then the charge and discharge state of the to-be-tested battery may be controlled based on the battery voltage corresponding to the upper limit of the initial usage interval and the battery voltage corresponding to the lower limit of the initial usage interval. On the other hand, after narrowing the state-of-charge usage interval to the limited usage interval in S103, a battery voltage corresponding to an upper limit of the limited usage interval and a battery voltage corresponding to a lower limit of the limited usage interval may also be determined based on the relationship curve. Consequently, the charge and discharge state of the to-be-tested battery may be controlled based on the battery voltage corresponding to the upper limit of the limited usage interval and the battery voltage corresponding to the lower limit of the limited usage interval.

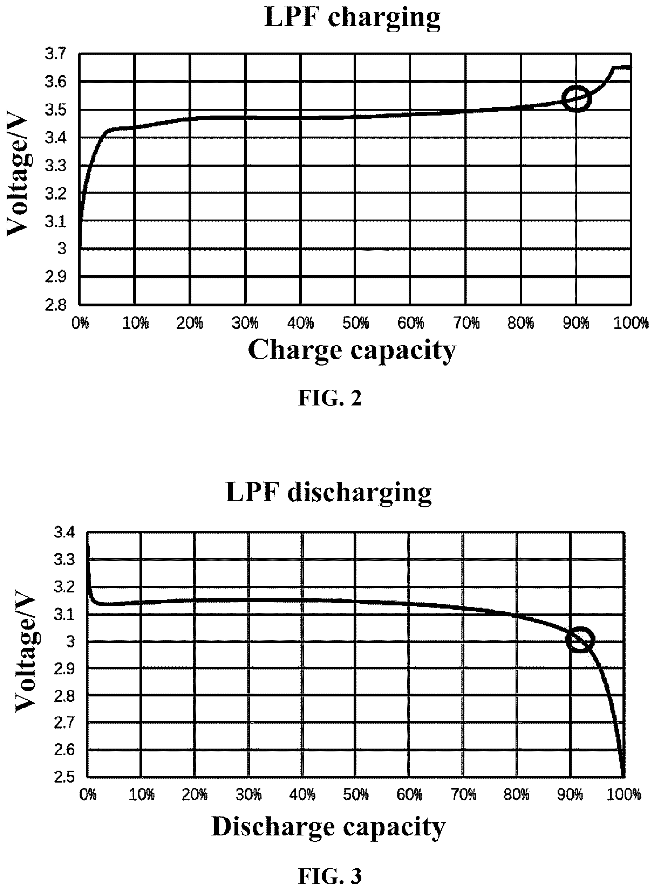

FIG. 2 illustrates a relationship curve between the charging voltage and the charge capacity of a lithium iron phosphate battery during a charging process according to an embodiment of the present application. FIG. 3 illustrates a relationship curve between the discharging voltage and the discharge capacity of a lithium iron phosphate battery during a discharging process according to an embodiment of the present application. With reference to FIGS. 2 and 3, in the case where the to-be-tested battery is a lithium iron phosphate (LFP) battery, based on the relationship curve between the charging voltage and charge capacity of the LFP battery, it can be determined that the battery voltage is 3.65 V when the battery is fully charged, and the battery voltage is 3.54 V when the battery is charged to 90% capacity (as indicated by the circled point in FIG. 2). Therefore, the battery voltage corresponding to the 90% state of charge (SOC) of the LFP battery during the charging process is 3.54 V, and the battery voltage corresponding to 100% SOC is 3.65 V. Thus, in practical applications, the charging process of the battery at different stages may be stopped and controlled based on the two voltage points. Based on the relationship curve between the charging voltage and discharge capacity of the LFP battery, it can be determined that the battery voltage is 2.5 V when the battery is fully discharged, and the battery voltage is 3.03 V when 90% of the capacity is discharged (as indicated by the circled point in FIG. 3). Therefore, the battery voltage corresponding to 10% SOC of the LFP battery during the discharging process is 3.03 V, and the battery voltage corresponding to 0% SOC is 2.5 V. Thus, in practical applications, the power consumption process of the battery at different stages may be stopped and controlled based on the two voltage points.

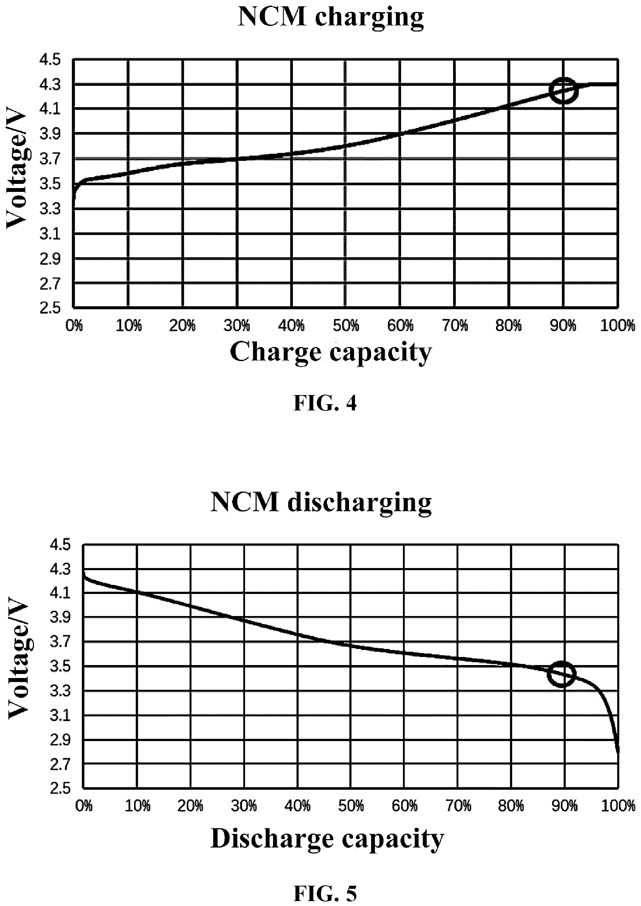

Similar to the LFP battery, FIG. 4 illustrates a relationship curve between the charging voltage and the charge capacity of a nickel cobalt manganese lithium battery during a charging process according to an embodiment of the present application, and FIG. 5 illustrates a relationship curve between the discharging voltage and the discharge capacity of a nickel cobalt manganese lithium battery during a discharging process according to an embodiment of the present application. With reference to FIGS. 4 and 5, in the case where the to-be-tested battery is a nickel cobalt manganese lithium (NCM) battery, based on the relationship curve between the charging voltage and charge capacity of the NCM battery, it can be determined that the battery voltage is 4.3 V when the battery is fully charged, and the battery voltage is 4.24 V when the battery is charged to 90% capacity (as indicated by the circled point in FIG. 4). Therefore, the battery voltage corresponding to the 90% SOC of the NCM battery during the charging process is 4.24 V, and the battery voltage corresponding to 100% SOC is 4.3 V. Thus, in practical applications, the charging process of the battery may be stopped and controlled based on the two voltage points. Based on the relationship curve between the charging voltage and discharge capacity of the NCM battery, it can be determined that the battery voltage is 2.8 V when the battery is fully discharged, and the battery voltage is 3.43 V when 90% of the capacity is discharged (as indicated by the circled point in FIG. 5). Therefore, the battery voltage corresponding to 10% SOC of the NCM battery during the discharging process is 3.43 V, and the battery voltage corresponding to 0% SOC is 2.8 V. Thus, in practical applications, the power consumption process of the battery may be stopped and controlled based on the two voltage points.

In S104, in response to the to-be-tested battery transitioning from the safety of life stage to the hazard of life stage, the to-be-tested battery is forcibly discharged to the lower limit of the limited usage interval.

The stage of the to-be-tested battery changes from the safety of life stage to the hazard of life stage, indicating that the health of the to-be-tested battery is reduced by 40% compared with the battery leaving the factory. In this case, the battery capacity is too different from that at the factory. If the battery continues to be used in this case, safety cannot be guaranteed, so the battery needs to be disabled. Before disabling, the battery power needs to be released to the lower limit of the limited usage interval to ensure that the battery power is as little as possible. On the one hand, if an energy storage battery retains a large amount of power at the time of decommissioning, the risks of short circuits, overheating, or even fire and explosions may increase. For example, the chemical substances within the battery may become unstable at high power, potentially leading to hazardous situations. On the other hand, the potential harm of low-power batteries to the environment is relatively small in the subsequent recycling and processing process. If the chemical substances in high-power batteries leak, more serious environmental pollution may be caused. Moreover, considering that batteries with a large amount of power need more special measures and equipment during transportation and processing, the processing cost increases. On the contrary, reducing the power to a minimum can reduce the relevant costs. Finally, when the battery is disassembled for reuse later, if the power is low, the risk of electric shock faced by operators and equipment is small, and it is also easier to separate and reuse the various components of the battery. For example, in some waste battery processing plants, if a battery received has too high power, the battery needs to be discharged first, which is not only time-consuming, but also increases the processing links and costs. On the contrary, reducing the power to a minimum in advance can make the entire processing process more efficient and safe.

In S105, after completing forced discharge, the state-of-charge usage interval of the to-be-tested battery is set to a single value.

The single value is equal to the lower limit of the limited usage interval. The purpose of setting the state-of-charge usage interval of the to-be-tested battery to the single value of the lower limit of the limited usage interval is to limit the to-be-tested battery to a single state of charge, prohibit the charging and discharging operations that cause the state of charge to fluctuate up and down, and thus disable the to-be-tested battery.

In the related art, the battery warranty period is typically divided into three application stages, that is, a beginning of life stage, a middle of life stage, and an end of life stage. Users are reminded to replace the battery during the end of life stage, and once the battery exceeds the warranty period, the battery is no longer covered by warranty or subject to corresponding management. However, many users often continue to use the battery regardless of the reminder to replace the battery. In such cases, failure to manage the battery accordingly significantly increases the likelihood of safety incidents. The embodiment of the present application determines five application stages for the battery, including not only the beginning of life stage, the middle of life stage, and the end of life stage within the warranty period but also a safety of life stage and a hazard of life stage beyond the warranty period. On the one hand, after the battery enters the end of life stage, the present application reduces the state-of-charge usage interval of the battery to align with changes in the state of health. Thus, it is ensured that the charge and discharge rates can be adjusted based on the state-of-charge usage interval, the charge and discharge behavior of the battery can better adapt to the state of health of the battery, and the battery life decay can be slowed down. On the other hand, the present application also sets a safe of life stage and a hazard of life stage after the battery exceeds the warranty period. The safety of life stage refers to a stage where the battery is able to maintain safe under the limited usage interval, indicating that users use the battery with confidence beyond the warranty period of the battery. Thus, user experience is enhanced. Moreover, in the hazard of life stage, the battery is discharged to its minimum capacity and then deactivated so that the battery is forced to be decommissioned. In this manner, harm to users is avoided after the battery safety factor significantly decreases, thereby improving battery safety.

In the method for battery derating protection provided by this embodiment, in an application process of a to-be-tested battery, application stages of the to-be-tested battery are correspondingly adjusted based on the decline of a state of health of the to-be-tested battery. In the case where the to-be-tested battery is in the beginning of life stage or the middle of life stage, a state-of-charge usage interval of the to-be-tested battery is set to an initial usage interval. In the case where the to-be-tested battery transitions from the middle of life stage to the end of life stage, the state-of-charge usage interval is narrowed to a limited usage interval. In the case where the to-be-tested battery transitions from the safety of life stage to the hazard of life stage, the to-be-tested battery is forcibly discharged to a lower limit of the limited usage interval. After completing forced discharge, the state-of-charge usage interval of the to-be-tested battery is set to a single value. In this manner, derating protection for the battery is achieved. On one hand, the derating protection of the state of charge is based on the state of health of the battery, which is scientific and reasonable, the shortening of battery life due to unreasonable derating is avoided, and the battery life is extended. On the other hand, the user's use of the battery beyond the warranty period is considered, and battery safety is enhanced.

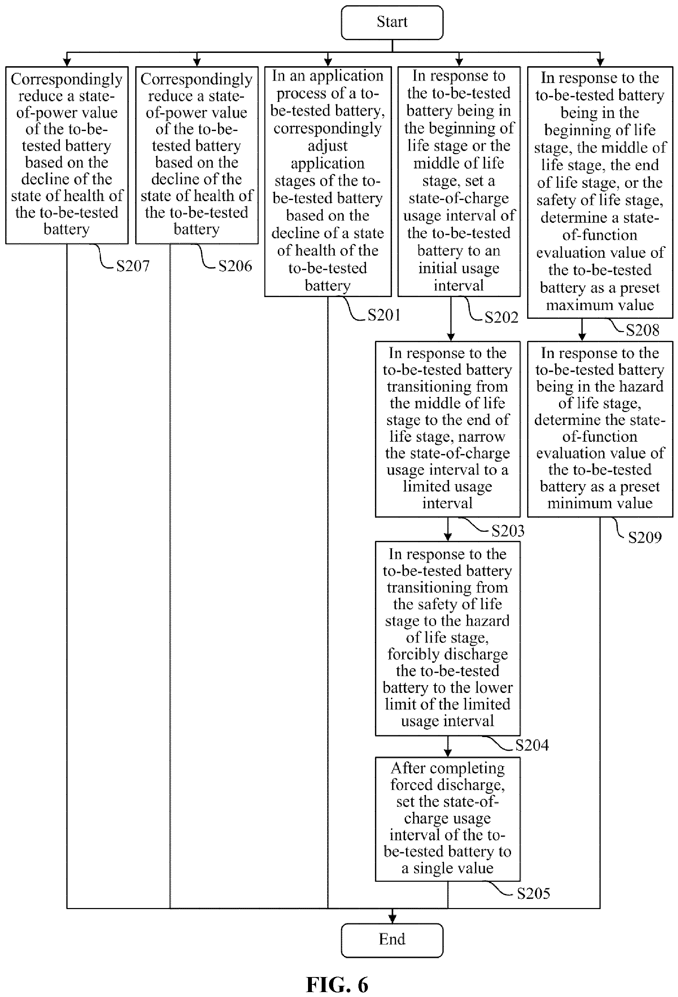

FIG. 6 is a flowchart of a method for battery derating protection according to an embodiment of the present application. Based on the preceding embodiments, with reference to FIG. 6, the method for battery derating protection includes S201 to S209.

In S201, in an application process of a to-be-tested battery, application stages of the to-be-tested battery are correspondingly adjusted based on decline of a state of health of the to-be-tested battery.

In S202, in response to the to-be-tested battery being in a beginning of life stage or a middle of life stage, a state-of-charge usage interval of the to-be-tested battery is set to an initial usage interval.

In S203, in response to the to-be-tested battery transitioning from the middle of life stage to an end of life stage, the state-of-charge usage interval is narrowed to a limited usage interval.

In S204, in response to the to-be-tested battery transitioning from the safety of life stage to a hazard of life stage, the to-be-tested battery is forcibly discharged to a lower limit of the limited usage interval.

In S205, after completing forced discharge, the state-of-charge usage interval of the to-be-tested battery is set to a single value.

S201, S202, S203, S204 and S205 correspond to S101, S102, S103, S104 and S105 of the preceding embodiment, respectively. The contents are the same and are not repeated here.

In S206, a state-of-power value of the to-be-tested battery is correspondingly reduced based on the decline of the state of health of the to-be-tested battery.

The state of power (SOP) value of the battery is used to describe the maximum power the battery is able to deliver or absorb at a specific moment and may also be understood as a quantitative value of the power tolerance of the battery. During the use of the battery, the battery management system may regulate the charge and discharge rates of the battery based on the SOP value of the battery, prevent the battery from being overcharged or over-discharged and prolonging the battery life. In this embodiment, the SOP value of the to-be-tested battery decreases as the SOH decreases. Illustratively, the SOP value of the to-be-tested battery may be equal to the SOH. Alternatively, the SOP value of the to-be-tested battery may also be reduced in steps based on the decline in the SOH. For example, in the beginning of life stage, in the case where the SOH range of the to-be-tested battery is (90%, 100%], the SOP value is 100%; in the middle of life stage, in the case where the SOH range of the to-be-tested battery is (80%, 90%], the SOP value is 90%; in the end of life stage, in the case where the SOH range of the to-be-tested battery is (70%, 80%], the SOP value is 80%; in the safe of life stage, in the case where the SOH range of the to-be-tested battery is (60%, 70%], the SOP value is 70%; in the hazard of life stage, in the case where the SOH range of the to-be-tested battery is (0, 60%], the battery is disabled, and the SOP value is 0%. Moreover, the SOP value determined based on the decline of the SOH may be only a basic value of the SOP value. The actual SOP value applied by the battery management system may be calculated by multiplying a temperature coefficient and/or a remaining capacity coefficient on this basis.

In S207, a state-of-safety estimation value of the to-be-tested battery is set to a preset maximum value.

The state-of-safety (SOS) estimation value of the to-be-tested battery is a quantitative evaluation result of the safety of the to-be-tested battery under specific circumstances and serves as the safety quantitative value displayed to users. In the case where the state-of-charge usage interval is set to change with the application stages and the battery is forcibly decommissioned during the hazard of life stage, the theoretical safety of the battery is ensured. In this case, the SOS estimation value may be set to the preset maximum value to show the superior safety of the battery to the users. Illustratively, the preset maximum value may be equal to 100%. Additionally, the SOS estimation value set in this step may only be a basic value of the SOS. The actual SOS value applied or displayed externally by the battery management system may be derived by multiplying at least one of the device aging coefficient, circuit aging coefficient, or temperature coefficient on this basis.

In S208, in response to the to-be-tested battery being in the beginning of life stage, the middle of life stage, the end of life stage, or the safety of life stage, a state-of-function evaluation value of the to-be-tested battery is determined as a preset maximum value.

The state-of-function (SOF) evaluation value of the to-be-tested battery is a quantitative value of the comprehensive performance evaluation of the overall functional state of the to-be-tested battery. In the case where both the SOC value and SOP value are adjusted accordingly based on the SOH, the maximum values of various functions are likewise adjusted accordingly based on the SOH. Thus, the to-be-tested battery can achieve corresponding functions across all non-forcibly decommissioned stages. In this embodiment, setting the SOF evaluation value to the preset maximum value in the beginning of life stage, the middle of life stage, the end of life stage, or the safety of life stage can accurately indicate the SOF of the battery in these stages. Illustratively, the preset maximum value may be 100%.

In S209, in response to the to-be-tested battery being in the hazard of life stage, the state-of-function evaluation value of the to-be-tested battery is determined as a preset minimum value.

The to-be-tested battery is in the hazard of life stage, indicating that the to-be-tested battery is disabled. In this case, all functions of the to-be-tested battery cannot be completed. Therefore, the SOF evaluation value of the to-be-tested battery is determined as the preset minimum value to truly indicate the SOF of the to-be-tested battery in the hazard of life stage. Illustratively, the preset minimum value may be 0%.

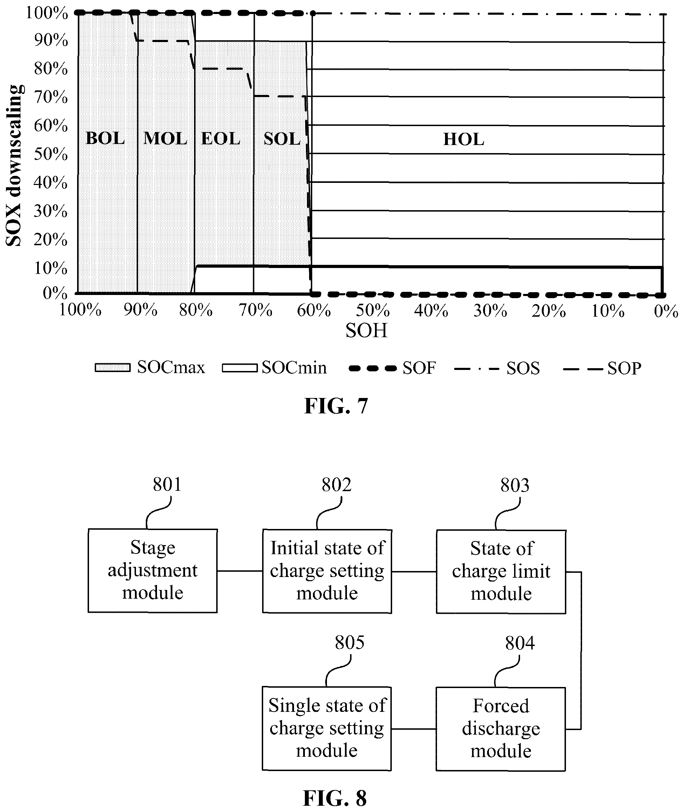

Illustratively, FIG. 7 is a diagram showing the variation curves of various parameters throughout the entire lifecycle of a to-be-tested battery according to an embodiment of the present application. The state of X (SOX) derating in the figure refers to the adjustment of the SOS, SOF, SOP, and SOC mentioned in this embodiment, where the SOC usage interval is represented by the maximum value SOCmax and the minimum value SOCmin; the application stages of the to-be-tested battery and the corresponding various state parameters of the SOH, SOS, SOF, SOP, and SOC usage interval are described in Table 2. Combined with FIG. 7 and Table 2, the SOH range corresponding to the BOL is (90%, 100%], and then corresponding to the SOH, the SOS is 100%, the SOF is 100%, the SOP is 100%, the minimum value SOCmin in the SOC usage interval is 0%, and the maximum value SOCmax is 100%. The SOH range corresponding to the MOL is (80%, 90%], and then corresponding to the SOH, the SOS is 100%, the SOF is 100%, the SOP is 90%, the minimum value SOCmin in the SOC usage interval is 0%, and the maximum value SOCmax is 100%. The SOH range corresponding to the EOL is (70%, 80%], and then corresponding to the SOH, the SOS is 100%, the SOF is 100%, the SOP is 80%, the minimum value SOCmin in the SOC usage interval is 10%, and the maximum value SOCmax is 90%. The SOH range corresponding to the SOL is (60%, 70%], and then corresponding to the SOH, the SOS is 100%, the SOF is 100%, the SOP is 70%, the minimum value SOCmin in the SOC usage interval is 10%, and the maximum value SOCmax is 90%. The SOH range corresponding to the HOL is (0, 60%], and then corresponding to the SOH, the SOS is 100%, the SOF is 0%, the SOP is 0%, the minimum value SOCmin in the SOC usage interval is 10%, and the maximum value SOCmax is 10%.

**Table 2 Comparison table of application stages and corresponding various state parameters of a to-be-tested battery**

| Appli cation Stage | SOH | SOS | SOF | SOP | SOCmax | SOCmin |
|---|---|---|---|---|---|---|
| BOL | (90%, 100%] | 100% | 100% | 100% | 100% | 0% |
| MOL | (80%, 90%] | 100% | 100% | 90% | | |
| EOL | (70%, 80%] | 100% | 100% | 80% | 90% | 10% |
| SOL | (60%, 70%] | 100% | 100% | 70% | | |
| HOL | (0, 60%] | 100% | 0% | 0% | 10% | 10% |

The method for battery derating protection provided in this embodiment reduces the state-of-power value of the to-be-tested battery based on the decline of the state of health of the to-be-tested battery. The state-of-safety estimation value of the to-be-tested battery is set to a preset maximum value. In the case where the to-be-tested battery is in the beginning of life stage, the middle of life stage, the end of life stage, or the safety of life stage, a state-of-function evaluation value of the to-be-tested battery is determined as a preset maximum value. In the case where the to-be-tested battery is in the hazard of life stage, the state-of-function evaluation value of the to-be-tested battery is determined as a preset minimum value. Thus, the method achieves the corresponding configuration of the battery's state-of-power value, state-of-power value, and state-of-function evaluation value at each stage. All state parameters are configured in alignment with the state of health, ensuring high reliability and prolonging the battery life while maintaining the safety level of the battery.

The present application also provides an apparatus for battery derating protection. FIG. 8 is a diagram illustrating the composition of an apparatus for battery derating protection according to an embodiment of the present application. Based on the preceding embodiments, with reference to FIG. 8, the apparatus 800 for battery derating protection includes a stage adjustment module 801, an initial state of charge setting module 802, a state of charge limit module 803, a forced discharge module 804, and a single state of charge setting module 805.

The stage adjustment module 801 is configured to: in an application process of a to-be-tested battery, correspondingly adjust application stages of the to-be-tested battery based on the decline of a state of health of the to-be-tested battery, where the application stages include a beginning of life stage, a middle of life stage, an end of life stage, a safety of life stage, and a hazard of life stage ranked from high to low according to the state of health.

The initial state of charge setting module 802 is configured to: in response to the to-be-tested battery being in the beginning of life stage or the middle of life stage, set a state-of-charge usage interval of the to-be-tested battery to an initial usage interval.

The state of charge limit module 803 is configured to: in response to the to-be-tested battery transitioning from the middle of life stage to the end of life stage, narrow the state-of-charge usage interval to a limited usage interval, where the range of the limited usage interval is less than the range of the initial usage interval.

The forced discharge module 804 is configured to: in response to the to-be-tested battery transitioning from the safety of life stage to the hazard of life stage, forcibly discharge the to-be-tested battery to the lower limit of the limited usage interval.

The single state of charge setting module 805 is configured to: after completing forced discharge, set the state-of-charge usage interval of the to-be-tested battery to a single value, where the single value is equal to the lower limit of the limited usage interval.

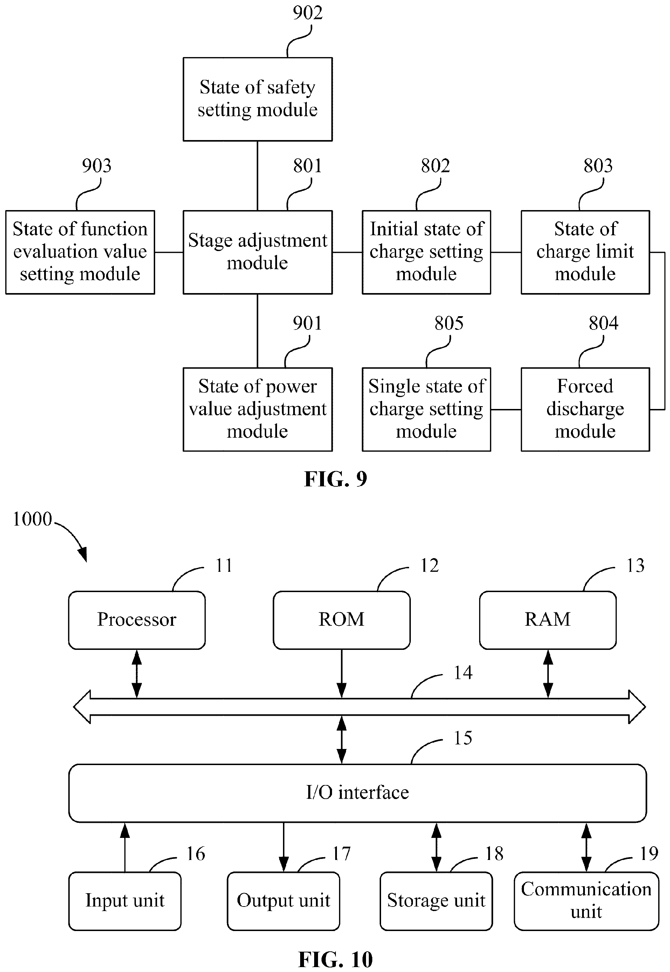

In some embodiments, FIG. 9 is a diagram illustrating the composition of another apparatus for battery derating protection according to an embodiment of the present application. Based on the preceding embodiments, with reference to FIG. 9, the apparatus for battery derating protection further includes at least one of a state of power value adjustment module 901, a state of safety setting module 902, and a state of function evaluation value setting module 903.

The state of power value adjustment module 901 is configured to correspondingly reduce state-of-power value of the to-be-tested battery based on the decline of the state of health of the to-be-tested battery.

The state of safety setting module 902 is configured to set a state of safety of the to-be-tested battery to a preset maximum value.

The state of function evaluation value setting module 903 is configured to: in the case where the to-be-tested battery is in the beginning of life stage, the middle of life stage, the end of life stage, or the safety of life stage, determine a state-of-function evaluation value of the to-be-tested battery as a preset maximum value; in the case where the to-be-tested battery is in the hazard of life stage, determine the state-of-function evaluation value of the to-be-tested battery as a preset minimum value.

The apparatus battery derating protection provided by this embodiment of the present application can perform the method for battery derating protection provided by the preceding embodiments of the present application and has functional modules and beneficial effects corresponding to the performing of the method.

FIG. 10 is a diagram illustrating the structure of an electronic device that can implement the embodiments of the present application. The electronic device is intended to represent various forms of digital computers, for example, a laptop computer, a desktop computer, a worktable, a personal digital assistant, a server, a blade server, a mainframe computer, or other applicable computers. The electronic device may also represent various forms of mobile apparatuses such as a personal digital processing apparatus, a cellular phone, a smart phone, a wearable device (for example, a helmet, glasses, a watch), and other similar computing apparatuses. The components shown herein, their connections and relationships, and their functions, are by way of examples only.

As shown in FIG. 10, the electronic device 1000 includes at least one processor 11 and a memory in a communication connection with the at least one processor 11, such as a read-only memory (ROM) 12 and a random-access memory (RAM) 13. The memory stores a computer program executable by the at least one processor. The processor 11 may perform various appropriate actions and processes based on computer programs stored in a ROM 12 or loaded from a storage unit 18 into a RAM 13. The RAM 13 may also store various programs and data needed for the operation of the electronic device 1000. The processor 11, the ROM 12, and the RAM 13 are connected to each other through a bus 14. An input/output (I/O) interface 15 is also connected to the bus 14.

Multiple components in the electronic device 1000 are connected to the I/O interface 15, including an input unit 16, such as a keyboard or a mouse; an output unit 17, such as various types of displays or speakers; a storage unit 18, such as a magnetic disk or an optical disk; and a communication unit 19, such as a network card, a modem, or a wireless communication transceiver. The communication unit 19 allows the electronic device 1000 to exchange information/data with other devices through a computer network such as the Internet and/or various telecommunication networks.

The processor 11 may be various general-purpose and/or special-purpose processing components having processing and computing capabilities. The processor 11 includes but is not limited to, a central processing unit (CPU), a graphics processing unit (GPU), various dedicated artificial intelligence (AI) computing chips, various processors running machine learning model algorithms, a digital signal processor (DSP), and any suitable processors, controllers, and microcontrollers. The processor 11 performs various methods and processes described above, such as a method for battery derating protection.

In some embodiments, the method for battery derating protection may be implemented as a computer program tangibly embodied in a computer-readable storage medium such as the storage unit 18. In some embodiments, part or all of the computer program may be loaded and/or installed on the electronic device 1000 via the ROM 12 and/or the communication unit 19. When the computer program is loaded into the RAM 13 and executed by the processor 11, one or more steps of the method for battery derating protection described above may be performed. In other embodiments, the processor 11 may be configured to perform the method battery derating protection by any other suitable means (for example, by means of firmware).

Various embodiments of the systems and techniques described above in the present application may be implemented in a digital electronic circuit system, an integrated circuit system, a field programmable gate array (FPGA), an application specific integrated circuit (ASIC), application specific standard parts (ASSPs), a system-on-chip system (state of charge), a complex programmable logic device (CPLD), computer hardware, firmware, software, and/or combinations thereof. The various implementations may include an implementation in one or more computer programs that may be executable and/or interpretable on a programmable system including at least one programmable processor. The programmable processor may be special-purpose or general-purpose for receiving data and instructions from a memory system, at least one input apparatus, and at least one output apparatus and transmitting the data and instructions to the memory system, the at least one input apparatus, and the at least one output apparatus.

The computer program for implementing the method of the present application may be written in any combination of one or more programming languages. These computer programs may be provided to a processor of a general-purpose computer, special-purpose computer, or other programmable data processing apparatus such that the computer programs, when executed by the processor, causes the functions/operations specified in flowcharts and/or block diagrams to be implemented. The computer program may be executed entirely or partly on the machine, as a stand-alone software package partly on the machine and partly on a remote machine, or entirely on the remote machine or server.

In the present application, a computer-readable storage medium may be a tangible medium that may contain or store a computer program for use by or in conjunction with an instruction execution system, apparatus, or device. The computer-readable storage medium may include electronic, magnetic, optical, electromagnetic, infrared, or semiconductor systems, apparatuses, or devices, or any suitable combination thereof. Optionally, the computer-readable storage medium may be a machine-readable signal medium. The machine-readable storage medium may include an electrical connection having one or more wires, a portable computer magnetic disk, a hard disk, a RAM, a ROM, an erasable programmable read-only memory (EPROM) or a flash memory, an optical fiber, a portable compact disc read-only memory (CD-ROM), an optical storage device, a magnetic storage device, or any suitable combination thereof.

To provide interaction with a user, the systems and techniques described herein may be implemented on an electronic device. The electronic device has a display apparatus (for example, a CRT (cathode ray tube) or an LCD (liquid crystal display) monitor) for displaying information to a user; and a keyboard and pointing apparatus (for example, a mouse or a trackball) through which a user can provide input to the electronic device. Other types of apparatuses may also be used for providing interaction with a user. For example, feedback provided for the user may be sensory feedback in any form (for example, visual feedback, auditory feedback, or haptic feedback). Moreover, input from the user may be received in any form (including acoustic input, voice input, or haptic input).

The systems and techniques described herein may be implemented in a computing system including a back-end component (for example, a data server), a computing system including a middleware component (for example, an application server), a computing system including a front-end component (for example, a client computer having a graphical user interface or a web browser through which a user can interact with implementations of the systems and techniques described herein), or a computing system including any combination of such back-end, middleware, or front-end components. Components of a system may be interconnected by any form or medium of digital data communication (for example, a communication network). Examples of the communication network include a local area network (LAN), a wide area network (WAN), a blockchain network, and the Internet.

The computing system may include a client and a server. A client and a server are generally remote from each other and typically interact through a communication network. The relationship between the client and the server arises by virtue of computer programs running on respective computers and having a client-server relationship to each other. The server, which may be a cloud server and is also referred to as a cloud computing server or a cloud host, is a host product in a cloud computing service system. The server solves the problems of difficult management and weak service scalability in the service of a related physical host and a related virtual private server (VPS).

It is to be understood that various forms of processes shown above may be adopted with steps reordered, added, or deleted. For example, the steps described in the present application may be performed in parallel, sequentially, or in different orders, as long as the desired results of the technical solutions of the present application can be achieved.

## Claims

1. A method for battery derating protection, comprising:
in an application process of a to-be-tested battery, correspondingly adjusting (101, 201) application stages of the to-be-tested battery based on decline of a state of health of the to-be-tested battery, wherein the application stages comprise a beginning of life stage, a middle of life stage, an end of life stage, a safety of life stage, and a hazard of life stage ranked from high to low according to the state of health;
in response to the to-be-tested battery being in the beginning of life stage or the middle of life stage, setting (102, 202) a state-of-charge usage interval of the to-be-tested battery to an initial usage interval;
in response to the to-be-tested battery transitioning from the middle of life stage to the end of life stage, narrowing (103, 203) the state-of-charge usage interval to a limited usage interval, wherein a range of the limited usage interval is less than a range of the initial usage interval;
in response to the to-be-tested battery transitioning from the safety of life stage to the hazard of life stage, forcibly discharging (104, 204) the to-be-tested battery to a lower limit of the limited usage interval; and
after completing forced discharge, setting (105, 205) the state-of-charge usage interval of the to-be-tested battery to a single value, wherein the single value is equal to the lower limit of the limited usage interval.

2. The method for battery derating protection according to claim 1, wherein while correspondingly adjusting the application stages of the to-be-tested battery based on the decline of the state of health of the to-be-tested battery, the method further comprises:
correspondingly reducing (206) a state-of-power value of the to-be-tested battery based on the decline of the state of health of the to-be-tested battery.

3. The method for battery derating protection according to claim 1, wherein while correspondingly adjusting the application stages of the to-be-tested battery based on the decline of the state of health of the to-be-tested battery, the method further comprises:
setting (207) a state-of-safety estimation value of the to-be-tested battery to a preset maximum value.

4. The method for battery derating protection according to claim 1, wherein while correspondingly adjusting the application stages of the to-be-tested battery based on the decline of the state of health of the to-be-tested battery, the method further comprises:
in response to the to-be-tested battery being in the beginning of life stage, the middle of life stage, the end of life stage, or the safety of life stage, determining (208) a state-of-function evaluation value of the to-be-tested battery as a preset maximum value; and
in response to the to-be-tested battery being in the hazard of life stage, determining (209) the state-of-function evaluation value of the to-be-tested battery as a preset minimum value.

5. The method for battery derating protection according to any one of claims 1 to 4, wherein before the to-be-tested battery leaves a factory, the method further comprises:
measuring a relationship curve between voltage and charge-discharge capacity of the to-be-tested battery during a charging and discharging process;
after setting the state-of-charge usage interval of the to-be-tested battery to the initial usage interval, the method further comprises:
determining, based on the relationship curve, a battery voltage corresponding to an upper limit of the initial usage interval and a battery voltage corresponding to a lower limit of the initial usage interval; and
controlling a charge and discharge state of the to-be-tested battery based on the battery voltage corresponding to the upper limit of the initial usage interval and the battery voltage corresponding to the lower limit of the initial usage interval; and
after narrowing the state-of-charge usage interval to the limited usage interval, the method further comprises:
determining, based on the relationship curve, a battery voltage corresponding to an upper limit of the limited usage interval and a battery voltage corresponding to a lower limit of the limited usage interval; and
controlling the charge and discharge state of the to-be-tested battery based on the battery voltage corresponding to the upper limit of the limited usage interval and the battery voltage corresponding to the lower limit of the limited usage interval.

6. The method for battery derating protection according to claim 5, wherein the to-be-tested battery comprises a lithium iron phosphate battery; wherein
in a case where the to-be-tested battery is the lithium iron phosphate battery, the battery voltage corresponding to the upper limit of the initial usage interval is 3.65 V, the battery voltage corresponding to the lower limit of the initial usage interval is 2.5 V, the battery voltage corresponding to the upper limit of the limited usage interval is 3.54 V, and the battery voltage corresponding to the lower limit of the limited usage interval is 3.03 V.

7. The method for battery derating protection according to claim 5, wherein the to-be-tested battery comprises a nickel cobalt manganese lithium battery;
in a case where the to-be-tested battery is the nickel cobalt manganese lithium battery, the battery voltage corresponding to the upper limit of the initial usage interval is 4.3 V, the battery voltage corresponding to the lower limit of the initial usage interval is 2.8 V, the battery voltage corresponding to the upper limit of the limited usage interval is 4.24 V, and the battery voltage corresponding to the lower limit of the limited usage interval is 3.43 V.

8. The method for battery derating protection according to any one of claims 1 to 4, wherein a range of the state of health corresponding to the beginning of life stage is (90%, 100%], a range of the state of health corresponding to the middle of life stage is (80%, 90%], a range of the state of health corresponding to the end of life stage is (70%, 80%], a range of the state of health corresponding to the safety of life stage is (60%, 70%], and a range of the state of health corresponding to the hazard of life stage is (0, 60%].

9. An electronic device, comprising:
at least one processor; and
a memory communicatively connected to the at least one processor;
wherein the memory stores a computer program executable by the at least one processor, and the computer program is configured to, when executed by the at least one processor, cause the at least one processor to execute the method for battery derating protection according to any one of claims 1 to 8.

10. A computer-readable storage medium storing computer instructions that, when executed by a processor, cause the processor to implement the method for battery derating protection according to any one of claims 1 to 8.
